# EUROPEAN PATENT SPECIFICATION

(11) **EP 2 388 802 B1**
(45) Date of publication and mention of the grant of the patent: **06.05.2015**
(21) Application number: 09838237.7
(22) Date of filing: 04.12.2009
(51) Int. Cl.: H01L 21/20, C23C 16/02, C30B 33/00, H01L 21/205, C30B 29/20, C30B 29/40, C30B 33/04, C30B 25/18, C30B 29/38, B23K 26/00, H01L 21/02

(54) **INSIDE REFORMING SUBSTRATE FOR EPITAXIAL GROWTH AND METHOD FOR PRODUCING THE SAME**
INNENREFORMIERUNGSSUBSTRAT FÜR EPITAXIALWACHSTUM SOWIE VERFAHREN ZU DESSEN HERSTELLUNG
SUBSTRAT DE REFORMAGE INTÉRIEUR POUR CROISSANCE ÉPITAXIALE ET SON PROCÉDÉ DE PRODUCTION

(30) Priority: 15.01.2009 JP 2009006293
(43) Date of publication of application: 23.11.2011
(73) Proprietor: NAMIKI SEIMITSU HOUSEKI KABUSHIKI KAISHA, Tokyo 123-8511 (JP); Disco Corporation, Tokyo 143-8580 (JP)
(72) Inventor: AIDA, Hideo, Tokyo 123-8511 (JP); AOTA, Natsuko, Tokyo 123-8511 (JP); HOSHINO, Hitoshi, Tokyo 143-8580 (JP)
(74) Representative: Prinz & Partner mbB
(86) International application number: PCT/JP2009/006633
(87) International publication number: WO 2010/082267

(56) References cited:
- JP-A- 2003 264 194
- JP-A- 2006 093 175
- JP-A- 2006 196 558
- JP-A- 2006 347 776
- JP-A- 2008 108 792
- HIRAMATSU ET AL: "Relaxation Mechanism of Thermal Stresses in the Heterostructure of GaN Grown on Sapphire by Vapor Phase Epitaxy", JAPANESE JOURNAL OF APPLIED PHYSICS (JJAP), vol. 32 Part 1, no. 4, 15 April 1993 (1993-04-15), pages 1528-1533, XP002690344, DOI: 10.1143/JJAP.32.1528
- BELOUSOV ET AL.: "In situ metrology advances in MOCVD growth of GaN-based materials", JOURNAL OF CRYSTAL GROWTH, vol. 272, no. 1-4, 10 December 2004 (2004-12-10), pages 94-99, XP002690347, DOI: 10.1016/j.jcrysgro.2004.08.080
- B. HOLLANDER ET AL.: 'Strain relaxation of pseudomorphic Si1-xGex/Si (100) heterostructures after hydrogen or helium ion implantation for virtual substrate fabrication' NUCLEAR INSTRUMENTS & METHODS IN PHYSICS RESEARCH SECTION B-BEAM INTERACTIONS WITH MATERIALS AND ATO vol. 175, April 2001, pages 357 - 367, XP004242660

## Description

### Field of the Invention

This invention concerns internally reformed substrates for epitaxial growth, monocrystalline growth body, device, and bulk substrate fabricated using them, and method of manufacture for these according to the present claim set.

### Technical Background

Because of their broad bandgap and their capability for emission of blue light, nitride semiconductors represented by gallium nitride are widely used for light-emitting diodes (LED) and semiconductor lasers (LD). In recent years there have been numerous efforts to improve light-emission efficiency and increase luminance.

The general structure of nitride light-emitting devices has been a double heterostructure in which a buffer layer of GaN, an n-type contact layer of n-GaN, an n-type clad layer of n-AlGaN, an active layer of n-lnGaN, and a p-type contact layer of p-AIGaN are stacked in that order on a sapphire substrate. Active layer structures include the single quantum well (SQW) structure which is one well layer of InₓGa1₋ₓN (where 0≤x≤1) and the multi quantum well (MQW) structure which has a well layer of InₓGa1₋ₓN (where 0≤x≤1) and a barrier layer of In_{y}Ga1_{-y}N (where 0≤x≤1 and y<x). (JP8330629)

It is known that when the gallium nitride layer is formed on the sapphire substrate by epitaxial growth, warping of the sapphire substrate occurs after layer formation because of the difference of indices of thermal expansion and the difference in lattice constant between the gallium nitride and the sapphire.

Jpn.J. Appl. Phys., Vol. 32 (1993), pp. 1528-1533 discusses how the thermal stress that develops through epitaxial growth of an AIN buffer layer and a GaN layer on a sapphire substrate can be eased, depending on the thickness of the GaN layer. It is clear from this Non-patent Document 1 that warping of the substrate increases as the thickness of the grown layer increases and stress is eased by the occurrence of the resultant interface defects, microcracks, dislocations, and macrocracks.

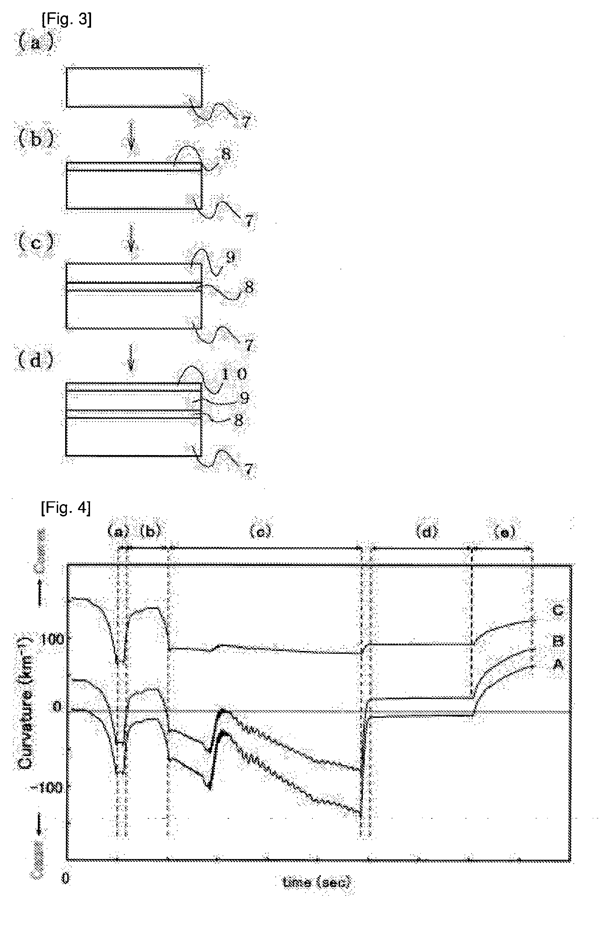

Moreover, fig. 4 of J. Cryst. Growth, Vol. 272, Issues 1-4 (2004), pp. 94-99 discloses an analytical method for in-situ observation of substrate warping that arises in the process of epitaxial growth of a GaN LED structure on a sapphire substrate. This indicates that the curvature of the sapphire substrate in a series of growth processes varies greatly with variations in the material of the growth layer, the growth temperature, and thickness of the layer.

Thus it was made clear that by means of a growth process such that the curvature of the sapphire substrate would be nearly 0 during growth of an InGaN layer that is the active layer, the light emission wavelength at the surface of the substrate can be made uniform.

As above, it is known that warping of a sapphire substrate varies greatly in a series of layer growth processes and that it affects the quality of nitride semiconductor layers and uniformity of the emitted wavelength.

In fact it is possible, using the difference in the index of thermal expansion from that of the substrate, to set the shape and amount of sapphire substrate warping so that there is nearly 0 substrate curvature in the InGaN active layer. Given that background, various polishing techniques have been considered in order to control the shape and amount of sapphire substrate warping (JP2006347776, for example).

When partitioning light-emitting elements that are nitride semiconductors stacked on a sapphire substrate, on the other hand, there is a known technology of condensing a pulsed laser within a sapphire substrate having a thickness of about 89 to 90 µm to form changed domains corresponding to the lines planned for partition of the light-emitting elements (JP2008006492). This document discloses a method of processing sapphire substrates by illuminating a sapphire substrate with a laser beam to suppress the loss of luminance of the light-emitting elements when partitioning into individual light-emitting elements; its purpose is the partitioning of light-emitting elements.

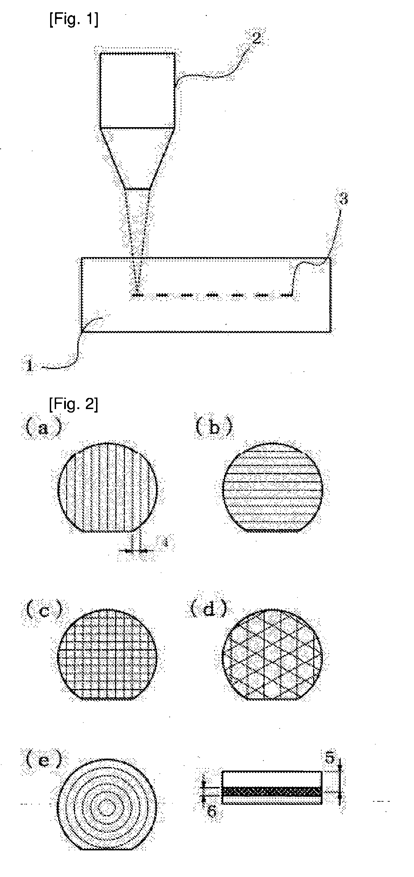

JP 2003264194 A discusses a laser gettering method for creating an amorphous region inside a substrate (FIG. 1). This amorphous serves for trapping of impurities inside the substrate material. It does not reduce the warping of the wafer.

As stated above, the warping of sapphire substrates through a series of growth processes to yield a gallium nitride light-emitting diode structure varies greatly, and so there is the problem of poor quality of the nitride semiconductor layer, poor uniformity of the emitted wavelength, and poor yield of light-emitting diodes.

The conventional method for dealing with this problem is that of setting the shape and amount of sapphire substrate warping so that the curvature of the substrate in the stage of InGaN active layer growth is nearly 0. In other words, it is a method of treating the sapphire substrate in advance to counteract the amount of warping that will occur in the stage of InGaN active layer growth. Although this method does hold down the scattering of the emitted wavelengths to some extent, there remains the unresolved problem of substrate warping that occurs during processes to grow layers other than the InGaN active layer.

Sapphire substrates warp greatly during the stage of n-GaN layer growth and as the substrates cool down after completion of layer formation, and so there are problems such as reduced layer quality and reduced uniformity of layer quality, as well as the difficulty of uniformity in the substrate back grinding process. Because these problems have a great effect on the yield of devices such as light-emitting diodes, it is necessary to suppress substrate warping and change of the amount of warping through all growth processes and to minimize substrate warping behavior itself. However, sapphire substrates of this sort have not existed heretofore.

There is the further problem that as sapphire substrates increase in diameter, it becomes more difficult to control the precise shape and amount of warping through the polishing process. It is known that in a sapphire substrate that has undergone a polishing process substrate warping normally occurs as a result of residual machining discrepancies and differences of surface coarseness between the top and bottom surfaces. In a substrate with one polished surface, for example, the cause of warping is primarily the difference of surface coarseness between the top and bottom surfaces, and in a substrate with two polished surfaces the cause of warping is slight variation in the surface coarseness of each face of the substrate in addition to slight differences of surface coarseness between the top and bottom surfaces.

There are technical problems, particularly in the case of large-diameter substrates, in making surface coarseness uniform between the substrate surfaces, and so there is the problem in the technical realm that the desired shape and amount of warping cannot be controlled precisely by the polishing process alone.

There is the further problem that when, in order to obtain a nitride semiconductor bulk substrate, one attempts epitaxial growth to such a thickness that the thick layer of nitride semiconductor can exist independently, there will be great warping of the sapphire substrate because of the different indices of thermal expansion of the sapphire and the nitride semiconductor and the amount of this warping will increase with the thickness of the layer formed. As a result, cracking may occur during and after layer growth, making it essentially impossible to obtain nitride semiconductor bulk substrates that can exist independently.

Means to resolve these problems have been proposed, including the epitaxial lateral over growth (ELOG) method, the dislocation elimination of inverted-pyramidal pits (DEEP) method, and the void-assisted separation (VAS) method, but they all have the defect that processes becomes complicated.

### Summary

The problems of the present invention are solved by the subjects of the independent claims. Advantages (preferred embodiments) are set out in the detailed description hereinafter, the figures as well as in the dependent claims. In consideration of these problems, it is an object of the invention, in the field of sapphire substrates used chiefly for epitaxial growth of nitride semiconductor layers, to provide a sapphire substrate of which the shape and/or amount of warping can be controlled efficiently and precisely and of which substrate warping that occurs during layer formation can be suppressed and substrate warping behavior can be minimized, to provide nitride semiconductor layer growth bodies, nitride semiconductor devices, and nitride semiconductor bulk substrates using such substrates, and to provide a method of manufacturing these products.

The present inventors discovered that by using a pulsed laser to form a reformed domain pattern within a sapphire substrate for epitaxial growth of a nitride semiconductor layer it is possible to control stresses in the sapphire substrate and to control efficiently the shape and/or amount of substrate warping.

Further, it was discovered that when the sapphire substrates obtained from this invention are used to form nitride semiconductor layers, the stresses generated by layer growth are counteracted by the stresses in the sapphire substrate in which the reformed domain pattern has been formed and it becomes possible to suppress substrate warping in the layer growth process and to minimize substrate warping behavior. With this discovery the invention was completed.

That is, among sapphire substrates used for formation of a semiconductor layer formed by epitaxial growth, the internally reformed sapphire substrate for epitaxial growth of a semiconductor layer of this invention is one in which a reformed domain pattern is formed within the sapphire substrate by means of multiphoton absorption using a pulsed laser condensed and scanned through a polished surface of the sapphire substrate.

Moreover, the internally reformed sapphire substrate for epitaxial growth of a semiconductor layer of this invention is fabricated by forming a reformed domain pattern within the sapphire substrate by means of multiphoton absorption using a pulsed laser condensed and scanned through a polished surface of the sapphire substrate.

Moreover, the internally reformed sapphire substrate for epitaxial growth of a semiconductor layer of this invention is one in which, in addition to the inventions described above, the plane shape of at least one type of reformed domain pattern is any of a striped shape, a lattice shape, a distribution of multiple polygons, a concentric circular shape, a spiral shape, or broken lines or dots that are symmetrical with respect to a vertical line through the center point of the sapphire substrate.

Moreover, the internally reformed sapphire substrate for epitaxial growth of a semiconductor layer of this invention is one in which the position of formation of at least one type of reformed domain pattern is between 3% and 95% of the thickness of the substrate from the growth surface of the internally reformed sapphire substrate and the pitch between lines making up the reformed domain pattern is at least 50 µm and no more than 2000 µm.

Moreover, the internally reformed sapphire substrate for epitaxial growth of a semiconductor layer of this invention is one in which the plane shape of at least one type of reformed domain pattern the plane shape of at least one type of reformed domain pattern is any of broken lines or dots that are symmetrical with respect to a vertical line through the center point of the internally reformed sapphire substrate or a lattice pattern and the reformed domain pattern is positioned between 3% and 50% of the thickness of the substrate from the growth surface of the sapphire substrate and the pitch between lines making up the reformed domain pattern is at least 50 µm and no more than 2000 µm.

Moreover, the nitride semiconductor layer growth body of this invention is one in which at least one nitride semiconductor layer is formed on the growth surface of an internally reformed sapphire substrate for epitaxial growth of nitride semiconductor layers.

Moreover, the nitride semiconductor device of this invention is one fabricated using the nitride semiconductor growth layer body of this invention.

Moreover, the bulk nitride semiconductor substrate of this invention is one fabricated using a thick nitride semiconductor layer of this invention.

Moreover, the internally reformed sapphire substrate for epitaxial growth of a nitride semiconductor layer of this invention is one fabricated using a sapphire substrate for formation of a reformed domain pattern which prior to formation of the reformed domain pattern has a semiconductor layer growth surface that is concave and the curvature of the concave surface is greater than 0 km⁻¹ and not greater than 160 km⁻¹.

Moreover, the internally reformed sapphire substrate for epitaxial growth of a nitride semiconductor layer of this invention is one fabricated using a sapphire substrate for formation of a reformed domain pattern which prior to formation of the reformed domain pattern has a semiconductor layer growth surface that is concave and the curvature of the concave surface is greater than 40 km⁻¹ and not greater than 150 km⁻¹.

Moreover, the internally reformed sapphire substrate for epitaxial growth of a nitride semiconductor layer of this invention is one fabricated using a sapphire substrate for formation of a reformed domain pattern which prior to formation of the reformed domain pattern has a semiconductor layer growth surface that is concave and the curvature of the concave surface is greater than 85 km⁻¹ and not greater than 150 km⁻¹.

Moreover, the sapphire substrate for reformed domain formation of this invention is one in which the diameter of the sapphire substrate prior to reformed domain formation is at least 50 mm and no more than 300 mm and its thickness is at least 0.05 mm and no more than 5.0 mm.

The internally reformed sapphire substrate of this invention can be applied in epitaxial growth of semiconductor layers of various types, including nitride semiconductor layers. Moreover, it [the invention] can be applied to any monocrystalline substrate other than sapphire selected from the group consisting of nitride semiconductor, Si, GaAs, quartz crystal or SiC, in which pattern formation of reformed domains can be done internally using a pulsed laser. In particular, it can be used with any monocrystalline substrate selected from the group consisting of sapphire, nitride semiconductor, Si, GaAs, quartz crystal or SiC used for epitaxial growth to resolve the problem of substrate warping that occurs in homoepitaxial growth, including unified and mixed-crystal systems, not just in heteroepitaxial growth. For that reason, it can improve the quality and yield of a variety of devices and bulk substrates.

Referring to the present invention the term "monocrystalline substrate", wherein the material of the monocrystalline substrate (1) is any of sapphire, nitride semiconductor, Si, GaAs, quartz crystal or SiC.

This invention has the effects described below.

Because of the invention described in claim 1 it is possible to provide, an internally reformed monocrystalline substrate (1) for epitaxial growth of monocrystalline layers obtainable by the inventive method, characterized in that reformed domain patterns (3) having a plane shape are formed within the monocrystalline substrate (1) by means of multiphoton absorption of a pulsed laser beam (2) for controlling a warp shape and / or an amount of warping of the monocrystalline substrate (1), wherein the material of the monocrystalline substrate (1) is any of sapphire, nitride semiconductor, Si, GaAs, quartz crystal or SiC. This invention is particularly effective in the case of large diameter substrates where control by the polishing process alone is technically difficult. There is the further effect that it is possible to provide monocrystalline substrates in which warping that occurs in the epitaxial growth process can be suppressed and substrate warping behavior can be minimized.

Because of the invention described in claim 2 it is possible to counteract the stresses that occur during layer formation with stresses in the monocrystalline substrate in which a reformed domain pattern has been formed, and so it is possible to suppress warping that occurs during layer formation and minimize substrate warping behavior.

This effect makes it possible to check dislocations during crystal formation and the lack of uniformity of layer thickness, and possible to obtain crystal layer formation bodies with improved layer quality and uniformity. It is possible to constitute various devices using the crystal layer formation bodies of this invention. Moreover, the crystal layer formation bodies of this invention can be used as bed substrates when using epitaxial growth to form thick layers of a thickness to exist independently.

Because of the invention described in claim 3 it is possible to constitute various devices using the crystal layer formation bodies with improved layer quality and uniformity, and so it is possible to provide various devices having improved quality and yields.

Because of the invention described in claim 4 it is possible to suppress substrate warping that occurs during and after layer growth, and so it is possible to grow thick layers without using complicated processes and without causing cracking. It is therefore possible to provide various bulk substrates that comprise thick crystal growth layers having a thickness to exist independently.

Because of the invention described in claim 5 it is possible to provide, among sapphire substrates used for epitaxial growth of semiconductor layers, sapphire substrates in which the shape and/or amount of substrate warping is efficiently and precisely controlled. Further, because reformed domain patterns are formed internally in the sapphire substrates of this invention, rewashing of the substrates is unnecessary. This invention is particularly effective for large diameter substrates for which control by the polishing process alone is technically difficult.

Moreover, using the sapphire substrate of this invention has the effect of making it possible to suppress substrate warping that occurs in the process of epitaxial growth of semiconductor layers and to minimize substrate warping behavior. Further, because the pattern is not on the surface of the sapphire substrate, there is no need for a major change of growth conditions and it is possible to conduct layer growth under the same conditions as conventional sapphire substrates.

Because of the invention described in claim 6 the stresses generated by formation of a semiconductor layer can be counteracted by stresses in the sapphire substrate in which a reformed domain pattern is formed, and so it is possible to suppress substrate warping that occurs in the process of epitaxial growth of semiconductor layers and to minimize substrate warping behavior.

As a result it is possible to check dislocations during crystal formation and the lack of uniformity of layer thickness, and possible to obtain crystal layer formation bodies with improved layer quality and uniformity. It is possible to constitute various devices using the crystal layer formation bodies of this invention. Moreover, the crystal layer formation bodies of this invention can be used as bed substrates when using epitaxial growth to form thick layers of a thickness to exist independently.

Because of the invention described in claim 7 it is possible to constitute various devices using the crystal layer formation bodies with improved layer quality and uniformity, and so it is possible to provide various semiconductor devices with improved quality and yield.

Because of the invention described in claim 8 it is possible to suppress substrate warping that occurs in the process of epitaxial growth of semiconductor layers, and so it is possible to grow thick layers without using complicated processes and without causing cracking. It is therefore possible to provide various bulk substrates that comprises thick crystal growth layers having a thickness to exist independently.

Because of the invention described in claim 9 it is possible to provide, among sapphire substrates used for epitaxial growth of nitride semiconductor layers, sapphire substrates in which the shape and/or amount of substrate warping is efficiently and precisely controlled. Further, because reformed domain patterns are formed internally in the sapphire substrates of this invention, rewashing of the substrates is unnecessary. This invention is particularly effective for large diameter substrates for which control by the polishing process alone is technically difficult.

Moreover, using the sapphire substrate of this invention has the effect of making it possible to suppress substrate warping that occurs in the process of epitaxial growth of semiconductor layers and to minimize substrate warping behavior. Further, because the pattern is not on the surface of the sapphire substrate, there is no need for a major change of growth conditions and it is possible to conduct layer growth under the same conditions as conventional sapphire substrates.

Because of the invention described in claim 10 there is, in addition to the effects of claim 9, the effect that it is possible to provide a sapphire substrate in which chiefly the shape of substrate warping is uniform.

Because of the invention described in claim 11 there is, in addition to the effects of claims 9 and 10, the effect that it is possible to provide a sapphire substrate in which chiefly the amount of substrate warping is uniform.

Because of the invention described in claim 12 there is, in addition to the effects of claims 9 and 10, the effect that it is possible to provide a sapphire substrate with which it is possible to suppress substrate warping that occurs in the process of epitaxial growth of semiconductor layers and to minimize substrate warping behavior.

Because of the invention described in claim 13 the stresses generated by formation of a semiconductor layer can be counteracted by stresses in the sapphire substrate in which a reformed domain pattern is formed, and so it is possible to suppress substrate warping that occurs in the process of epitaxial growth of semiconductor layers and to minimize substrate warping behavior.

This effect makes it possible to check dislocations in the nitride semiconductor layer and the lack of uniformity of layer thickness, and possible to obtain nitride semiconductor layer formation bodies with improved layer quality and uniformity. It is possible to constitute various nitride semiconductor devices using the nitride semiconductor layer formation bodies of this invention. Moreover, the nitride semiconductor layer formation bodies of this invention can be used as bed substrates when using epitaxial growth to form thick layers of a thickness to exist independently.

Because of the invention described in claim 14 it is possible to constitute various devices using the nitride semiconductor layer formation bodies with improved layer quality and uniformity, and so it is possible to provide various nitride semiconductor devices with improved quality and yield.

Because of the invention described in claim 15 it is possible to provide, in particular, photo-emitter elements, electron devices, or photo-receptor elements as nitride semiconductor devices.

Because of the invention described in claim 16 it is possible to suppress substrate warping that occurs during and after layer growth of nitride semiconductor layers, and so it is possible to grow thick nitride semiconductor layers without using complicated processes and without causing cracking. It is therefore possible to provide various nitride semiconductor bulk substrates that comprise thick nitride semiconductor layers having a thickness to exist independently.

Because of the invention described in claim 17 it is possible to provide bulk nitride semiconductor substrates in which the bulk nitride semiconductor substrate comprises AlₓIn_{y}Ga_{z}N (where x+y+z=1, x≥0, y≥0, and z≥0).

Because of the invention described in claim 18 it is possible to fabricate internally reformed sapphire substrates of which the shape and/or amount of warping can be controlled precisely.

Because of the invention described in claims 19 and 20 there is, in addition to the effects of claim 18, the effect that it is possible to fabricate internally reformed sapphire substrates with which it is possible to suppress substrate warping that occurs in the process of epitaxial growth of nitride semiconductor layers and to minimize substrate warping behavior.

Because of the invention described in claim 21 it is possible to efficiently fabricate internally reformed sapphire substrates with which it is possible to precisely control the shape and/or amount of substrate warping, to suppress substrate warping that occurs in the process of epitaxial growth of nitride semiconductor layers.

According to claim 22 Because of the invention described in claim 22 it is possible to precisely control the shape and/or amount of monocrystalline substrate warping, wherein the material of the monocrystalline substrate is sapphire, nitride semiconductor, Si, GaAs, quartz crystal, or SiC. This invention is particularly effective in the case of large diameter substrates where control by the polishing process alone is technically difficult.

Because of the invention described in claim 23 it is possible to suppress substrate warping that occurs in the process of epitaxial growth of substrate semiconductor layers and to minimize substrate warping behavior, and so it is possible to check dislocations during crystal formation and the lack of uniformity of layer thickness, and possible to improve layer quality and uniformity.

Because of the invention described in claim 24 it is possible to constitute various device using the crystal layer formation bodies with improved layer quality and uniformity, and so it is possible to provide various devices having improved quality and yields.

Because of the invention described in claim 25 it is possible to suppress substrate warping that occurs during and after layer growth, and so it is possible to grow thick layers without using complicated processes and without causing cracking. It is therefore possible to provide various bulk substrates that comprise thick crystal growth layers having a thickness to exist independently.

Because of the invention described in claim 26 it is possible to efficiently and precisely control substrate warp shape and/or amount in sapphire substrates used for epitaxial growth of nitride semiconductor layers. This invention is particularly effective for large diameter substrates for which control by the polishing process alone is technically difficult. Further, because reformed domain patterns are formed internally in the sapphire substrates of this invention, rewashing of the substrates is unnecessary.

Because of the invention described in claim 27 it is possible to suppress substrate warping that occurs in the process of epitaxial growth of semiconductor layers and to minimize substrate warping behavior, and so it is possible to check dislocations during semiconductor layer formation and the lack of uniformity of layer thickness, and possible to improve layer quality and uniformity. Further, because the pattern is not on the surface of the sapphire substrate, there is no need for a major change of growth conditions and it is possible to conduct layer growth under the same conditions as conventional sapphire substrates.

Because of the invention described in claim 28 it is possible to constitute various semiconductor devices with improved layer quality and uniformity, and so it is possible to manufacture various nitride semiconductor devices with improved quality and yield.

Because of the invention described in claim 29 it is possible to suppress substrate warping that occurs during and after layer growth, and so it is possible to grow thick layers without using complicated processes and without causing cracking. It is therefore possible to provide various bulk substrates that comprise thick semiconductor layers having a thickness to exist independently.

Because of the invention described in claim 30 it is possible to efficiently and precisely control substrate warp shape and/or amount in sapphire substrates used for epitaxial growth of nitride semiconductor layers. This invention is particularly effective for large diameter substrates for which control by the polishing process alone is technically difficult. Further, because reformed domain patterns are formed internally in the sapphire substrates of this invention, rewashing of the substrates is unnecessary.

Because of the invention described in claim 31 there is, in addition to the effects of claims 30, the effect that it is possible to provide a sapphire substrate in which chiefly the shape of substrate warping is uniform.

Because of the invention described in claim 32 there is, in addition to the effects of claim 31, the effect that it is possible to provide a sapphire substrate in which chiefly the amount of substrate warping is uniform.

Because of the invention described in claim 33 there is, in addition to the effects of claims 30 through 32, the effect that it is possible to provide a sapphire substrate with which it is possible to suppress substrate warping that occurs in the process of epitaxial growth of semiconductor layers and to minimize substrate warping behavior.

Because of the invention described in claim 34 it is possible to suppress substrate warping that occurs during layer formation and to minimize substrate warping behavior, and so it is possible to check dislocations in the nitride semiconductor layer and the lack of uniformity of layer thickness and to improve layer quality and uniformity. Further, because the pattern is not on the surface of the sapphire substrate, there is no need for a major change of growth conditions and it is possible to conduct layer growth under the same conditions as conventional sapphire substrates.

Because of the invention described in claim 35 it is possible to constitute various devices using the nitride semiconductor layer formation bodies with improved layer quality and uniformity, and so it is possible to manufacture various nitride semiconductor devices with improved quality and yield.

Because of the invention described in claim 36 it is possible to improve the quality and yield of nitride semiconductor devices, particularly photo-emitter elements, electron devices, or photo-receptor elements.

Because of the invention described in claim 37 it is possible to suppress substrate warping that occurs during and after layer growth, and so it is possible to grow thick layers without using complicated processes and without causing cracking. It is therefore possible to manufacture various bulk substrates that comprise thick nitride semiconductor layers having a thickness to exist independently.

Because of the invention described in claim 38 it is possible to manufacture, without cracking, thick nitride semiconductor layers that comprise, in particular, AlₓIn_{y}Ga_{z}N (where x+y+z=1, x≥0, y≥0, and z≥0).

Because of the invention described in claim 39 it is possible to fabricate efficiently internally reformed sapphire substrates in which the shape and/or amount of substrate warping is precisely controlled.

Because of the invention described in claims 40 and 41 there is the effect, in addition to that of claim 39, that it is possible to efficiently manufacture internally reformed sapphire substrates in which the shape and/or amount of substrate warping is precisely controlled and with which it is possible, in the process of forming nitride semiconductor layers, to suppress substrate warping and minimize substrate warping behavior.

Because of the invention described in claim 42 it is possible to efficiently manufacture internally reformed sapphire substrates in which the shape and/or amount of substrate warping is precisely controlled and with which it is possible, in the process of forming nitride semiconductor layers, to suppress substrate warping and minimize substrate warping behavior.

### Brief Description of Drawings

Fig. 1 is a diagram showing formation of a reformed domain within a monocrystalline substrate of an embodiment of this invention.
Fig. 2 is a diagram showing the pattern shape, pitch, and position of a reformed domain pattern of this embodiment.
Fig. 3 is a diagram showing the process of epitaxial growth of a nitride semiconductor layer of this embodiment.
Fig. 4 is a diagram showing an example of in-situ observation during the semiconductor growth process of this embodiment.
Fig. 5 is a diagram showing the relationship between warp amount and curvature of a substrate of this embodiment.
Fig. 6 is a diagram showing an example of in-situ observation using a sapphire substrate of this invention in this embodiment.
Fig. 7 is a diagram showing formation position and pitch dependence relative to the amount of change of substrate curvature following formation of the reformed domain pattern in embodiment 2.
Fig. 8a is a diagram showing the results of in-situ observation of sample 10 of embodiment 3.
Fig. 8b is a diagram showing the results of in-situ observation of sample 12 of embodiment 3.
Fig. 8c is a diagram showing the results of in-situ observation of sample 14 of embodiment 3.
Fig. 8d is a diagram showing the results of in-situ observation of sample 16 of embodiment 3.
Fig. 8e is a diagram showing the results of in-situ observation of sample 18 of embodiment 3.
Fig. 8f is a diagram showing the results of in-situ observation of sample 20 of embodiment 3.

### Detailed Description

Embodiments of the invention are explained below.

The internally reformed substrate for epitaxial growth of this invention is fabricated by condensing and scanning a pulsed laser through the polished surface of a monocrystalline substrate into the monocrystalline substrate used for layer growth of a crystalline layer by means of epitaxial growth, thus forming a reformed domain pattern by using multiphoton absorption by the pulsed laser, the monocrystalline substrate material is sapphire, nitride semiconductor, Si, GaAs, quartz crystal, or SiC, in which reformed domains can be formed internally using multiphoton absorption with a pulsed laser.

The wavelength of the pulsed laser used should be longer than the absorption edge wavelength of the monocrystalline substrate chosen and within the transparent wavelength region. The pulse width and irradiation energy must be selected to match the properties of the substrate material.

When the monocrystalline substrate is sapphire, the pulsed laser wavelength is preferably at least 200 nm and no more than 5000 nm, the pulse width is in the picosecond or femtosecond range, preferably from 200 fs to 800 fs, and the pulse repetition rate is preferably from 50 kHz to 500 kHz. The laser power is preferably 0.05 to 0.8 W and the laser spot size is 0.5 to 4 µm; the spot size is preferably about 2 µm. The scan speed of the sample stage is preferably 100 to 1000 mm/s in consideration of mass production.

Table 1 shows typical machining conditions that can form reformed domains in Si, GaAs, and quartz crystal.

**[Table 1]**

| | Si | GaAs | Quartz Crystal |
|---|---|---|---|
| Wavelength (nm) | 1064 | 1064 | 1045 |
| Pulse width (sec) | 120 x 10⁻⁹ | 70 x 10⁻⁹ | 500 x 10⁻¹⁵ |
| Pulse Repetition Rate (kHz) | 100 | 15 | 100 |
| Spot Size (µm) | 1.5 | 1.5 | 1 |
| Laser Power (W) | 0.3 to 1.2 | 0.2 | 0.4 |
| Stage Scan Speed (mm/s) | 200 to 300 | 200 | 400 |

For Si, GaAs, and quartz crystal the spot size is preferably in the range from 0.5 µm to 4 µm. The stage scan speed is 50 mm/s to 1000 mm/s, or 100 mm/s to 1000 mm/s in consideration of mass production. The pulse width is preferably 50 ns to 200 ns for Si, 30 ns to 80 ns for GaAs, and 200 fs to 800 fs for quartz crystal. The irradiation energy is preferably 3 µJ to 12 µJ for Si, 8 µJ to 20 µJ for GaAs, and 3 µJ to 6 µJ for quartz crystal. The pulse repetition rate is preferably 10 kHz to 500 kHz.

The size of the inventive monocrystalline substrate is not limited; diameters from 50 mm to 300 mm can be used. Substrates with thicknesses from 0.05 mm to 5.0 mm can be used.

The inventive monocrystalline substrate should be polished, at least on the surface used for formation of a crystalline layer formed by epitaxial growth. Warping normally occurs in inventive monocrystalline substrates because of residual machining distortions or differences in surface coarseness from the polishing process. For example, in a substrate with one polished surface, for example the cause of warping is primarily the difference of surface coarseness between the top and bottom surfaces, and in a substrate with two polished surfaces the cause of warping is slight variation in the surface coarseness of each face of the substrate in addition to slight differences of surface coarseness between the top and bottom surfaces.

The term "epitaxial growth" includes homoepitaxial growth, both unified and mixed-crystal systems, as well as heteroepitaxial growth.

As shown in figure 1, when a pulsed laser 2 is condensed into an inventive monocrystalline substrate 1 through its polished surface and scanned at a constant speed with the sample stage, spot-shaped reformed domains 3 are continuously connected to form a linear reformed domain.

Viewed locally, the spot-shaped reformed domain 3 is formed only in the portion irradiated instantaneously by the pulsed laser; its size depends on the laser's spot size, the laser intensity and the pulse width. Further, the separation of the spot-shaped reformed domains formed linearly depends on the laser's pulse repetition rate and the scan speed of the stage.

Combining these linear reformed domains forms at least one type of reformed domain pattern at the desired position, in the direction of depth, in the substrate. The term "reformed domain" indicates the changed layer formed by the local occurrence of multiphoton absorption in the area irradiated by the laser.

As shown in fig. 2, it is possible to control the stresses in the substrate as a whole and precisely control the shape and amount of substrate warping by optimizing such conditions as the pattern shape of the reformed domain pattern, the pitch 4 between lines, the formation position 5, and the reformed layer length 6.

With regard to the pattern shape, as shown in fig. 2 the plane shape can be, for example, a striped shape with multiple lines formed perpendicular or parallel to the orientation flat of the substrate (fig. 2 (a) and (b)) or a lattice combining these two directions (fig. 2 (c)). Other possible shapes are a distribution of multiple polygons (fig. 2 (d)), concentric circles (fig. 2 (e)), and so on.

Because the pattern shape primarily affects the symmetry of the substrate warping shape, if a warping shape that is uniform across the surface of the substrate is to be obtained, the preferable plane shape is a pattern of broken lines or dots that are symmetrical with respect to a vertical line through the center point of the substrate. Conversely, if the plane shape is striped it is possible to impose a bias to the warping shape of the substrate.

The pitch 4 between lines primarily affects the amount of change of the and amount of warping in the substrate following the reformed domain pattern formation; the smaller the pitch between lines, the larger the amount of change. Because decreasing the pitch increases the machining time, 50 µm to 2000 µm is preferable, and 100 µm to 1000 µm is better yet when mass production is taken into consideration.

The formation position 5 primarily affects the amount of change of the and amount of warping in the substrate following the reformed domain pattern formation; the closer the formation position to the surface, the greater the amount of change. To avoid affecting the growth surface of an inventive monocrystalline substrate, the formation position of at least one type of reformed domain pattern is preferably set to at least 3% and no more than 95% of substrate thickness and better yet at least 3% and no more than 50%, measuring from the growth surface of the substrate. Multiple reformed domain patterns can be formed at formation positions that differ in the direction of the depth of the substrate.

The reformed layer length 6 depends on the laser's spot size, irradiation energy (laser power divided by the pulse repetition rate), and pulse width; it is normally formed with a depth from several microns to several tens of microns.

As stated above, internally reformed substrates with precisely controlled warping shapes and/or amounts can be obtained efficiently by forming reformed domain patterns within the inventive monocrystalline substrates and controlling the stresses in the substrates.

Further, it is possible to form at least one crystal layer by epitaxial growth on the growth surface of the internally reformed substrate yielded by this invention and to fabricate crystal growth bodies. The method of formation of the crystalline layer can be either vapor phase growth or liquid phase growth. For example, various crystal growth methods such as MBE, CVD, VPE, LPE, or sublimation can be used.

Using the internally reformed substrate of this invention it is possible to counteract the stresses that occur through layer formation with the stresses of the internally reformed substrate, and so it is possible to suppress substrate warping in the layer growth process and to minimize substrate warping behavior. It is therefore it possible to obtain crystal growth layer bodies with increased crystalline layer quality and uniformity.

Using the crystal growth layer bodies obtained through this invention it is possible to improve device quality and yield when constituting various devices.

Further, it is possible to use the crystal growth layer body of this invention as a bed substrate for epitaxial growth to form a thick crystalline layer of a thickness to exist independently. Further, it is possible to separate the thick crystalline layer from the bed substrate that is a crystal growth layer body to yield a bulk substrate.

Moreover, it is possible to obtain a bulk substrate that comprises a thick crystalline growth layer by forming a thick crystalline growth layer on the internally reformed substrate of this invention and separating it from the internally reformed substrate. When using the internally reformed substrate of this invention, it is possible to suppress substrate warping that occurs during or after layer growth, and so it is possible to form a thick layer without cracking.

The independent thick layer is preferably at least 50 µm thick. Such methods as MOCVD, HVPE or LPE can be used to form the thick layer.

By using a sapphire substrate as the monocrystalline substrate it is possible to obtain an internally reformed sapphire substrate that has the same effects as the internally reformed substrate described above, and that is suited to formation of semiconductor layers by means of epitaxial growth.

Further, it is possible to fabricate a semiconductor layer growth body by using epitaxial growth to form at least one semiconductor layer on the growth surface of the internally reformed sapphire substrate of this invention. Using the semiconductor layer growth bodies obtained through this invention it is possible to obtain semiconductor devices and semiconductor bulk substrates.

Particularly when the semiconductor layer is a nitride semiconductor layer, it is possible to use sapphire substrates diameters from 50 mm to 300 mm as substrates for the growth of nitride semiconductors. Because the effects of this invention are greater in substrates of larger diameter, the invention is particularly useful for large diameter substrates of 75 mm or more and preferably of 150 mm or more. Despite that, there is no limit on the substrate size.

The thickness of the sapphire substrates used for growth of nitride semiconductors can be from 0.05 mm to 5.0 mm. A substrate thickness of 0.1 mm is preferable in order to form a reformed domain pattern in a position that will not break the sapphire substrate itself. Better yet is a thickness of at least 0,3 mm when the diameter of the substrate is from 50 mm to 150 mm, and at least 0.5 mm when the substrate diameter exceeds 150 mm.

The growth surface of the nitride semiconductor is concave and the curvature of this concave surface can be from 0 km⁻¹ up to 160 km⁻¹.

In the case of reformed domain patterns formed inside sapphire substrates used for growth of nitride semiconductor layers, the plane shape of the pattern, as stated above is any of a striped shape, a lattice shape, a distribution of multiple polygons, a concentric circular shape, a spiral shape, or broken lines or dots that are symmetrical with respect to a vertical line through the center point of the sapphire substrate. To obtain an internally reformed sapphire substrate having a uniform warping shape and amount in the substrate surface, it is preferable to use any of broken lines or dots that form a symmetrical pattern with respect to a vertical line through the center point of the substrate or a lattice pattern.

A pitch between lines of 50 µm to 2000 µm is preferable, and 100 µm to 1000 µm is better yet; 200 µm to 500 µm is even better when mass production is taken into consideration.

The formation position of at least one type of reformed domain pattern is preferably set to at least 3% and no more than 95% of substrate thickness and better yet at least 3% and no more than 50%, measuring from the growth surface of the substrate. Multiple reformed domain patterns can be formed at formation positions that differ in the direction of the depth of the substrate.

It has been the practice when partitioning light-emitting elements having a nitride semiconductor layer stacked on a sapphire substrate to back-grind the sapphire substrate following formation of the nitride semiconductor layer to a thickness of about 100 µm, and then form a pattern for partitioning within the sapphire substrate, but a reformed domain pattern with the plane shape of a lattice established prior to formation of the nitride semiconductor layer can also be used for the final partitioning of LED chips. In this case it is preferable to form the pattern at a position such that the pattern will remain within the thickness that remains following the process of back-grinding to substrate.

Fig. 3 (a) through (d) shows the process of epitaxial growth of a nitride semiconductor layer on a sapphire substrate. Such methods as MOCVD, HVPE, and MBE can be used for layer formation. First the sapphire substrate undergoes thermal cleaning (fig. 3 (a)), followed by growth of a low-temperature buffer layer 8 (fig. 3 (b)). Next comes the growth of an n-GaN layer 9 (fig. 3 (d)) and an InGaN active layer 10 with a multi quantum well structure (fig. 3 (d)).

Fig. 4 shows an example of in-situ observation during the process of epitaxial growth of a nitride semiconductor layer. As described in Non-Patent Document 2, it is possible to perform quantitative analysis, through in-situ observation, of sapphire substrate behavior during layer growth. That is, it can be known how a substrate's warping shape and amount change during layer growth.

In fig. 4 the horizontal axis shows time and the vertical axis shows curvature (km⁻¹) of the substrate growth surface. The positive direction of the vertical axis shows increasing convexity of the growth surface and the negative direction shows increasing concavity of the growth surface.

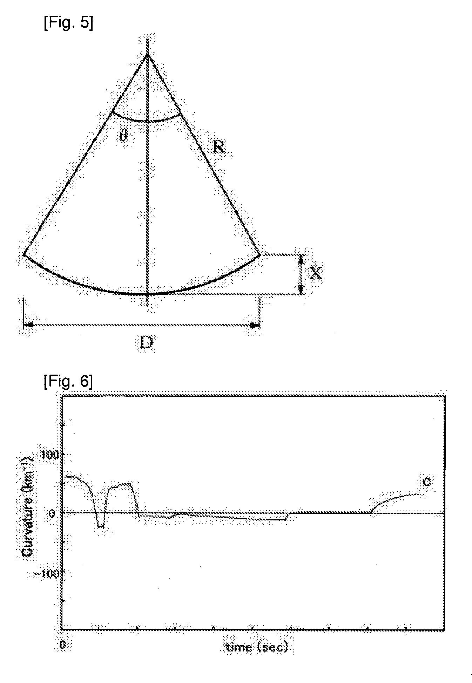

It is possible to calculate the amount of substrate warping from the curvature of the substrate. That is, as shown in fig. 5, with R the substrate curvature radius as R, the amount of warping X (µm) of a substrate with curvature 1/R can be found using the substrate diameter as an approximation of D; simply put, when the diameter of the substrate is 50 mm, it is 0.322 times the curvature (km⁻¹) and when the diameter of the substrate is 150 mm, it is 1.250 times the curvature (km⁻¹).

Spectrum A in fig. 4 shows an example using a conventional sapphire substrate without reformed domain formation.

In fig. 4, (a) through (e) correspond to the course of each layer formation process. That is, (a) corresponds to thermal cleaning of the substrate, (b) to growth of a low-temperature buffer layer, (c) to growth of an n-GaN layer, (d) to growth of an InGaN active layer, and (e) to the cool-down process.

Spectrum A of fig. 4 is used to explain the behavior of the substrate in fig. 4 (a) through (e).

In the stage of transition to (a) thermal cleaning, the concavity of the substrate growth surface intensifies because of the temperature difference between the upper and lower surfaces of the sapphire substrate, and curvature changes greatly.

Next the temperature drops, normally to about 500 to 600°C, and in the stage of transition to (b) growth of the low-temperature buffer layer the concavity of the substrate weakens and curvature is slightly reduced.

Next the temperature rises to 1000°C again and in the transition to (c) growth of the n-GaN layer the concavity of the substrate growth surface intensifies because of the difference between the lattice constants of the nitride semiconductor and the sapphire substrate, and curvature changes greatly. As layer growth progresses the curvature increases in proportion to the thickness of the layer, and so uniformity of layer thickness and layer quality on the surface of the substrate deteriorates markedly. It is said to be difficult technically to control uniformity of the substrate surface by means of layer growth conditions alone. Within the nitride semiconductor layer there is the problem, moreover, that dislocations occur to relieve stress and layer quality deteriorates.

Next the temperature drops to about 700 to 800 °C and in the transition to the stage of (d) InGaN system activity layer growth the uniformity the thickness of the InGaN system activity layer and of the In composition within the InGan affect the uniformity of the light-emitting wavelength surface and thus affect the production yield of LED chips. Because the thickness of the InGaN system activity layer and the In composition are affected by the layer growth temperature, the ideal is to make the curvature of the substrate as close to 0 as possible during layer growth in order to improve the temperature uniformity on the surface of the substrate.

Finally in the substrate's (e) cool-down stage, the shape of the substrate is again warped greatly by the difference in indices of thermal expansion, and so the substrate's curvature at the end of the series of layer growth processes is great. This causes the problem that the process of back-grinding before cutting into LED chips is difficult.

As described above with reference to spectrum A, when the conventional sapphire substrate is used it is possible to make the substrate curvature nearly 0 in the InGaN active layer growth stage, but there is the shortcoming that the substrate's behavior is great during the layer growth processes and there is no way to avoid a large substrate curvature on completion of layer growth.

Next in-situ observation example No. 1, in which a nitride semiconductor layer is grown on the internally reformed sapphire substrate of this invention fabricated by forming a reformed domain pattern within a conventional sapphire substrate, is shown by spectrum B in fig. 4.

For the initial state of the internally reformed sapphire substrate in spectrum B it is preferable to for a reformed domain pattern such that the substrate surface has a warp even more convex than the conventional sapphire substrate. It is possible by this means to reduce the substrate warping behavior relative to spectrum A, which used a conventional sapphire substrate.

As the initial convexity in spectrum B was greater than that in spectrum A, in spectrum C of fig. 4 the pitch between lines and the pattern formation position were adjusted when forming a reformed domain pattern within a conventional sapphire substrate and the initial state of the sapphire substrate was warped with an even greater convexity than in spectrum B.

In spectrum C it is possible to further reduce substrate behavior through the layer formation processes. That is, it shows the effect of counteracting stresses generated during layer growth by stresses in the substrate that is even greater than shown in spectra A and B.

In comparison with the case of use of a conventional sapphire substrate, the nitride semiconductors from which spectra B and C above were obtained showed suppressed warping of the substrates during layer growth and reduced substrate warping behavior, and so layer quality and uniformity were improved.

At the same time, however, there is the problem that the initial state of the internally reformed sapphire substrates was a greatly warped convex surface, and as a result the substrate curvature in the InGaN active layer growth stage and at the completion of layer growth was greater than when a conventional sapphire substrate was used.

That is, it is preferable that the internally reformed sapphire substrate of this invention have, as shown in spectrum C in fig. 6, reduced substrate warping behavior and at the same time reduced substrate curvature in the InGaN active layer growth stage and at the completion of layer growth.

It is possible by this means to improve the layer quality and uniformity of the nitride semiconductor layer and also to improve the light-emitting wavelength uniformity of nitride semiconductor photo-emitter elements.

It is desirable, therefore, that sapphire substrates prepared in advance to counteract the highly convex substrate curvature that would result from reformed domain pattern formation be used as the sapphire substrates prior to formation of the reformed domain patterns.

As stated previously, it is possible to use as the sapphire substrate for reformed pattern formation one that has a concave layer formation surface on the nitride semiconductor layer, the curvature of the concave surface being greater than 0 km⁻¹ and no more than 160 km⁻¹. And for the reasons stated previously, it is preferable that the layer growth surface of the nitride semiconductor layer be concave and that the curvature of this concave surface be between 40 km⁻¹ and 150 km⁻¹, and better yet between 85 km⁻¹ and 150 km⁻¹.

As described above, it is possible by using the internally reformed sapphire substrates of this invention to obtain nitride semiconductor layer growth bodies with improved nitride semiconductor layer quality and uniformity.

Using the nitride semiconductor layer growth bodies of this invention it is possible to constitute nitride semiconductor devices, including photo-emitter elements, electron devices, or photo-receptor elements, having improved quality and yield.

Further, it is possible by epitaxial growth on the nitride semiconductor layer growth bodies of this invention to form thick of nitride semiconductor layers to a thickness that can exist independently, then separate the nitride semiconductor layer growth bodies used as bed substrates to yield nitride semiconductor bulk substrates that comprise thick nitride semiconductor layers.

When a thick nitride semiconductor layer is formed on the internally reformed sapphire substrate of this invention it is possible to suppress substrate warping that occurs during or after the process of growth of the layer, and so it is possible to grow thick nitride semiconductor layers having a thickness to exist independently without causing cracking. By removing the thick nitride semiconductors layers thus obtained from the internally reformed sapphire substrates it is possible to provide bulk substrates of nitride semiconductor without the use of complicated processes. As nitride semiconductor bulk substrates t is possible to manufacture, in particular, nitride semiconductor bulk substrates that comprise AlₓIn_{y}Ga_{z}N (where x+y+z=1, x≥0, y≥0, and z≥0).

Next is a concrete explanation of embodiments of this invention. Reformed domain patterns were formed within sapphire substrates using the laser conditions shown in table 2, and the effect on substrate warping shape and amount of the substrate were examined. The results are shown in embodiments 1 and 2.

**[Table 2]**

| | |
|---|---|
| Wavelength (nm) | 1045 |
| Pulse Width (sec) | 500 × 10⁻¹⁵ |
| Pulse Repetition Rate (kHz) | 100 |
| Spot Size (µm) | 1.6 to 3.5 |
| Laser Power (W) | 0.3 |
| Stage Scan Speed (mm/s) | 400 |

### (Embodiment 1)

Two-inch sapphire substrates with one surface polished were used as the sapphire substrates for formation of reformed domain patterns. The substrate thickness was 430 µm. The shape and amount of substrate warping prior to formation of the reformed domain patterns was measured with a laser interferometer.

Next the sapphire substrates were mounted on the sample stage of a pulsed laser apparatus and reformed domain patterns were formed within the sapphire substrates.

Table 3 shows the pattern shapes, pitches between lines, formation positions reformed layer length, and machining time per substrate for samples 1 through 9. Following formation of the reformed domain patterns the substrate shape of the sapphire substrates was measured with a laser interferometer and the amount of warping and substrate thickness were measured with a linear gauge and a laser interferometer. "O.F." in table refers to the orientation flat of the substrate.

**[Table 3]**

| Sample No. | Pattern Shape | Pitch (µm) | Formation position (µm) | Reformed Layer Length (µm) | Machining Time (min) |
|---|---|---|---|---|---|
| No. 1 | Stripe (perpendicular to O.F.) | 100 | 110 | 25 | 5 |
| No. 2 | | | 230 | 30 | 5 |
| No. 3 | | | 350 | 40 | 5 |
| No. 4 | Stripe (parallel to O.F.) | | 110 | 25 | 5 |
| No. 5 | | | 230 | 30 | 5 |
| No. 6 | | | 350 | 40 | 5 |
| No. 7 | Lattice | | 110 | 25 | 10 |
| No. 8 | | | 230 | 30 | 10 |
| No. 9 | | | 350 | 40 | 10 |

Table 4 shows shape and amount of substrate warping before and after formation of reformed domain patterns and the symmetry of warping shape of the substrate surfaces following pattern formation. The substrate warp shape shown is the shape of the growth surface.

**[Table 4]**

| Sample No. | Before Pattern Formation | | After Pattern Formation | | |
|---|---|---|---|---|---|
| | Shape | Warp (µm) | Shape | Warp (µm) | Symmetry |
| No. 1 | Concave | 3 | Convex | 40 | Change of shape parallel to O.F. |
| No. 2 | Concave | 4 | Concave | 4 | |
| No. 3 | Concave | 5 | Concave | 20 | |
| No. 4 | Concave | 4 | Convex | 40 | Change of shape perpendicular to O.F. |
| No. 5 | Concave | 3 | Concave | 3 | |
| No. 6 | Concave | 5 | Concave | 20 | |
| No. 7 | Concave | 2 | Convex | 40 | Concentric change |
| No. 8 | Concave | 2 | Concave | 2 | |
| No. 9 | Concave | 3 | Concave | 20 | |

### (Embodiment 2)

Four-inch sapphire substrates with one surface polished were used as the sapphire substrates for formation of reformed domain patterns. The substrate thickness was 650 µm. As with embodiment 1, the shape and amount of substrate warping prior to formation of the reformed domain patterns was measured with a laser interferometer.

Next the sapphire substrates were mounted on the sample stage of a pulsed laser apparatus and reformed domain patterns were formed within the sapphire substrates. Table 5 shows the pattern shapes, pitches, and formation positions for samples 10 through 19.

**[Table 5]**

| Sample No. | Pattern Shape | Pitch (µm) | Formation position (µm) |
|---|---|---|---|
| No. 10 | Lattice | 500 | 110 |
| No. 11 | | 500 | 110 |
| No. 12 | | 500 | 340 |
| No. 13 | | 500 | 340 |
| No. 14 | | 500 | 570 |
| No. 15 | | 500 | 570 |
| No. 16 | | 500 and 500 | 110 and 570 |
| No. 17 | | 500 and 500 | 110 and 570 |
| No. 18 | | 500 and 250 | 110 and 570 |
| No. 19 | | 430 | 110 |

Following formation of the reformed domain patterns the warping shape of the substrates was measured with a laser interferometer and the amount of warping and substrate thickness was measured with a linear gauge. Table 6 shows a comparison of the shape and amount of substrate warping before and after formation of reformed domain patterns and the curvature calculated from the amount of warping. The substrate warp shape shown is the shape of the growth surface.

**[Table 6]**

| | Before Pattern Formation | | | After Pattern Formation | | |
|---|---|---|---|---|---|---|
| | Shape | Warp (µm) | Curvature (km⁻¹) | Shape | Warp (µm) | Curvature (km⁻¹) |
| No. 10 | Concave | 7 | 5.6 | Convex | 47 | 37.6 |
| No. 11 | Concave | 7 | 5.6 | Convex | 52 | 41.6 |
| No. 12 | Concave | 14 | 11.2 | Concave | 10 | 8 |
| No. 13 | Concave | 6 | 4.8 | Concave | 8 | 6.4 |
| No. 14 | Concave | 8 | 6.4 | Concave | 12 | 9.6 |
| No. 15 | Concave | 9 | 7.2 | Concave | 11 | 8.8 |
| No. 16 | Concave | 8 | 6.4 | Convex | 50 | 40 |
| No. 17 | Concave | 10 | 8 | Convex | 46 | 36.8 |
| No. 18 | Concave | 9 | 7.2 | Convex | 47 | 37.6 |
| No. 19 | Concave | 7 | 5.6 | Convex | 63 | 50.4 |

Table 7 shows the dependence on formation position and pitch between lines of the amount of change in substrate curvature following reformed domain pattern formation.

### (Embodiment 3)

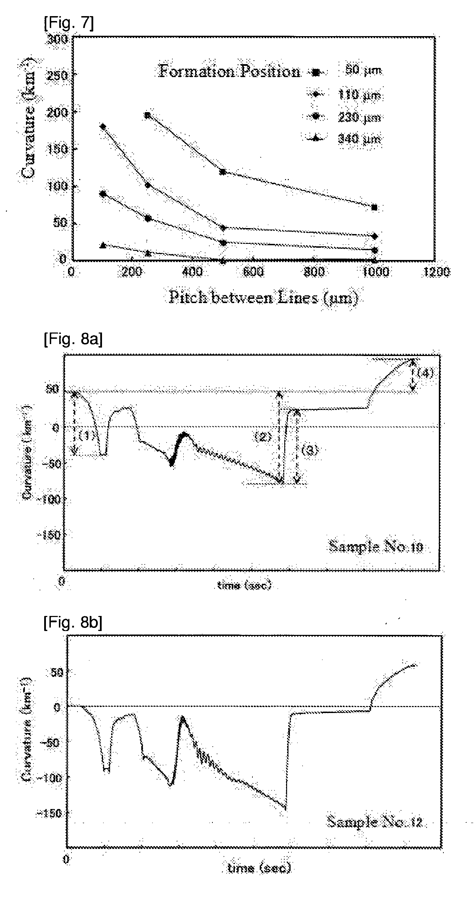

Of the sapphire substrates in which reformed domain patterns were formed in embodiment 2, samples 10, 12, 14, 16, and 18 and a conventional sapphire substrate in which no pattern had been formed (sample 20) were introduced simultaneously into an MOCVD apparatus and gallium nitride layers were grown on the sapphire substrates. Figure 7 shows the layer growth temperature and layer thickness in each growth processes.

**[Table 7]**

| | Growth Temperature (°C) | Layer Thickness (nm) |
|---|---|---|
| AlGaN buffer layer | 550 | 500 |
| n-GaN layer | 1070 | 5000 |
| GaN/InGaN active layer | 750 | 100/2 |

Results of in-situ observation of the samples are shown in fig. 8a through fig. 8f. Table 8 shows the substrate warping shape and amount and the curvature for each sample and table 9 shows the amount of curvature change in each stage.

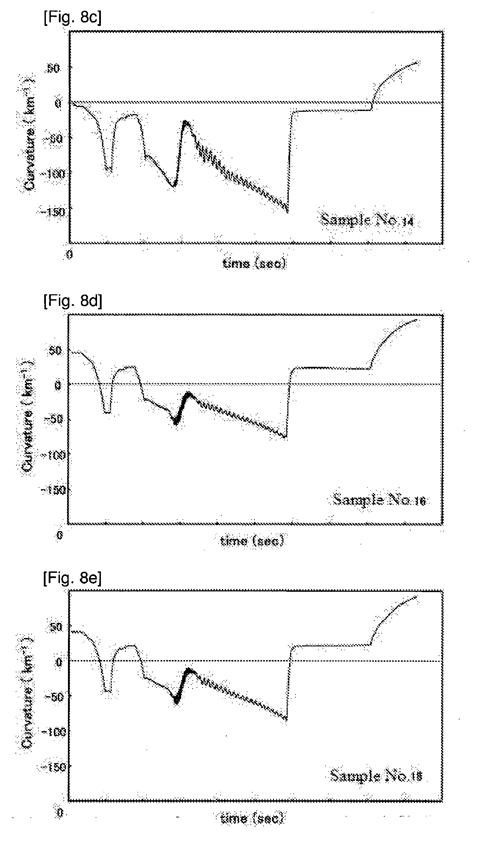

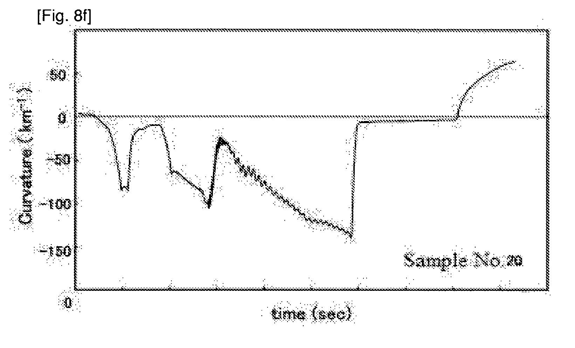

In table 9, (1) through (4) indicate the change (1) at the time of thermal cleaning transition relative to the initial shape of the substrates, (2) at the time of n-GaN layer growth relative to the initial shape of the substrates, (3) at the time of GaN/InGaN layer growth transition relative to the completion of n-GaN growth, and (4) at completion of the cool-down relative to the initial shape of the substrates, as shown in figure 8.

**[Table 8]**

| Sample No. | Substrate Shape | Warp (µm) | Curvature (km⁻¹) |
|---|---|---|---|
| No. 10 | Convex | 47 | 37.6 |
| No. 12 | Concave | 10 | 8 |
| No. 14 | Concave | 12 | 9.6 |
| No. 16 | Convex | 50 | 40 |
| No. 18 | Convex | 47 | 36.8 |
| No. 20 | Concave | 2 | 1.6 |

**[Table 9]**

| Sample No. | Curvature Change (km⁻¹) | | | |
|---|---|---|---|---|
| | (1) at time of thermal cleaning transition relative to initial shape of substrate | (2) at time of n-GaN layer growth relative to initial shape of substrate | (3) at time of GaN/InGaN layer growth transition relative to completion of n-GaN growth | (4) at completion of cool down relative to initial shape of substrate |
| No. 10 | 88 | 126 | 101 | 44 |
| No. 12 | 89 | 142 | 131 | 58 |
| No. 14 | 90 | 144 | 134 | 59 |
| No. 16 | 86 | 121 | 101 | 50 |
| No. 18 | 85 | 119 | 97 | 48 |
| No. 20 | 85 | 138 | 129 | 60 |

(1) Judging from the amount of change in substrate curvature at the time of thermal cleaning transition relative to the initial shape of the substrates, no major difference in the amount of curvature change was found among samples 10, 12, 14, 16, and 18, which were sapphire substrates in which reformed domain patterns have been formed, and sample 20, a conventional sapphire substrate in which no pattern had been formed.
(2) Judging from the amount of change in substrate curvature at the time of n-GaN layer growth relative to the initial shape of the substrates, a greater effect in suppressing substrate curvature change at the time of n-GaN layer growth was found in samples 10, 16 and 18, which had patterns formed in positions there were shallow in distance from the surface of the sapphire substrate, than in the other samples.
(3) Judging from the amount of change in substrate curvature at the time of GaN/InGaN layer growth transition relative to the completion of n-GaN growth, a greater effect in suppressing substrate curvature change at the time of GaN/InGaN layer growth transition relative to the completion of n-GaN growth was found in samples 10, 16 and 18, which had patterns formed in positions there were shallow in distance from the surface of the sapphire substrate, than in the other samples.
(4) Judging from the amount of change in substrate curvature at completion of the cool-down relative to the initial shape of the substrates, a greater effect in suppressing substrate curvature change was found in samples 10, 16 and 18, which had patterns formed in positions there were shallow in distance from the surface of the sapphire substrate, than in the other samples.

Investigation was made of the gallium nitride layer thickness uniformity and crystal quality in samples 10, 12, 14, 16, 18, and 20 obtained from the processes above.

It was found that in comparison with sample 20 in which a reformed domain pattern had not been formed, sample 10 had better uniformity of layer thickness. It is thought that this is because the pattern formation position was shallow in distance from the surface of the sapphire substrate, and so n-GaN layer formation took place with the substrate shape in a flatter state.

The FWHM values of the gallium nitride (001) plane and (102) plane found by X-ray diffraction rocking curve measurement were 203 arcsec and 418 arcsec for sample 10 and 242 arcsec and 579 arcsec for sample 20 in which no reformed domain pattern had been formed. From that result it can be seen that sample 10 in which a reformed domain pattern had been formed had a gallium nitride layer with better crystal than sample 20 in which no reformed domain pattern had been formed.

It can be seen from the results above that when epitaxial growth of a nitride semiconductor layer is performed using the internally reformed sapphire substrate of this invention it is possible to suppress substrate warping and minimize substrate warping behavior, and so layer quality and uniformity is improved.

### Reference Signs

- 1: Monocrystalline Substrate
- 2: Pulsed Laser
- 3: Reformed Domain
- 4: Pitch
- 5: Formation Position
- 6: Reformed Layer Length
- 7: Sapphire Substrate
- 8: Low-temperature Buffer Layer
- 9: n-GaN Layer
- 10: InGaN Active Layer

## Claims

1. An internally reformed monocrystalline substrate (1) for epitaxial growth of monocrystalline layers obtainable by the method of anyone of claims 22 to 42 ,**characterized in that** reformed domain patterns (3) having a plane shape are formed within the monocrystalline substrate (1) by means of multiphoton absorption of a pulsed laser beam (2) for controlling a warp shape and / or an amount of warping of the monocrystalline substrate (1), wherein the material of the monocrystalline substrate (1) is any of sapphire, nitride semiconductor, Si, GaAs, quartz crystal or SiC.

2. The internally reformed monocrystalline substrate (1) according to claim 1 having a growth surface for epitaxial growth, wherein at least one crystal layer is formed on the growth surface in a crystal growth layer body.

3. The internally reformed monocrystalline substrate (1) according to claim 2, wherein the crystal growth layer body is a crystal growth layer body in a device.

4. The internally reformed monocrystalline substrate (1) according to claim 2, wherein the crystal growth layer is a thick layer in a bulk substrate.

5. The internally reformed monocrystalline substrate according to claim 1, wherein the monocrystalline substrate is a sapphire substrate for epitaxial growth of a semiconductor layer.

6. The internally reformed monocrystalline substrate according to claim 5, wherein at least one semiconductor layer is formed on a growth surface of the sapphire substrate in a semiconductor layer growth body.

7. The internally reformed monocrystalline substrate according to claim 6, wherein the semiconductor growth layer body is a growth layer body in a semiconductor device.

8. The internally reformed monocrystalline substrate according to claim 6, wherein the semiconductor layer is a thick layer in a bulk semiconductor substrate.

9. The internally reformed monocrystalline substrate (1) according to claim 1, wherein the monocrystalline substrate (1) is a sapphire substrate (7) for epitaxial growth of a nitride semiconductor layer.

10. The internally reformed monocrystalline substrate (1) according to claim 9, wherein the plane shape of at least one type of the reformed domain patterns is any of a striped shape, a lattice shape, a distribution of multiple polygons, a concentric circular shape, a spiral shape or broken lines or dots that are symmetrical with respect to a vertical line through the center point of the sapphire substrate (7).

11. The internally reformed monocrystalline substrate (1) according to claim or 9 or 10, wherein the position of formation of the at least one type of reformed domain pattern is between 3% and 95% of the thickness of the sapphire substrate (7) from the growth surface of the sapphire substrate (7) and a pitch (4) between lines making up the reformed domain pattern (3) is at least 50 µm and no more than 2000 µm.

12. The internally reformed monocrystalline substrate (3) according to claim 9 or 10 wherein the plane shape of the at least one type of reformed domain pattern (3) is any of broken lines or dots that are symmetrical with respect to a vertical line through the center point of the sapphire substrate or a lattice pattern and the reformed domain pattern is positioned between 3% and 50% of the thickness of the sapphire substrate (7) from the growth surface of the sapphire substrate (7) and the pitch between lines making up the reformed domain pattern (3) is at least 50 µm and no more than 2000 µm.

13. The internally reformed monocrystalline substrate (1) according to anyone of claims 9 to 12, having a growth surface for epitaxial growth, wherein at least one nitride semiconductor layer is formed on the growth surface in a nitride semiconductor layer growth body.

14. The internally reformed monocrystalline substrate (1) according to claim 13, wherein the internally reformed monocrystalline substrate is a monocrystalline substrate in a nitride semiconductor device.

15. The internally reformed monocrystalline substrate (1) according to claim 14, wherein the nitride semiconductor device is any of a photo-emitter element, an electron device or a photo-receptor element.

16. The internally reformed monocrystalline substrate (1) according to claim 13, wherein the nitride semiconductor layer is a thick layer in a bulk nitride semiconductor substrate.

17. The internally reformed monocrystalline substrate (1) according to claim 16, wherein the bulk nitride semiconductor substrate comprises AlₓIn_{y}Ga_{z}N, wherein x+y+z=1, x≥0, y≥0 and z≥0.

18. The internally reformed monocrystalline substrate (1) according to anyone of claims 5 to 17, wherein the shape of the sapphire substrate (7) prior to formation of the reformed domain pattern (3) has a semiconductor layer growth surface that is concave and the curvature of the concave surface is greater than 0 km⁻¹ and not greater than 160 km⁻¹.

19. The internally reformed monocrystalline substrate (1) according to anyone of claims 5 to 17, wherein the shape of the sapphire substrate (7) prior to formation of the reformed domain pattern (3) has a semiconductor layer growth surface that is concave and the curvature of the concave surface is greater than 40 km⁻¹ and not greater than 150 km⁻¹.

20. The internally reformed monocrystalline substrate (1) according to anyone of claims 5 to 17, wherein the shape of the sapphire substrate (7) prior to formation of the reformed domain pattern (3) has a semiconductor layer growth surface that is concave and the curvature of the concave surface is greater than 85 km⁻¹ and not greater than 150 km⁻¹.

21. The internally reformed monocrystalline substrate (1) according to anyone of claims 18 to 20, wherein a diameter of the sapphire substrate (7) prior to formation of the reformed domain pattern (3) is at least 50 mm and no more than 300 mm and its thickness is at least 0,05 mm and no more than 5,0 mm.

22. A method of manufacturing reformed domain substrates for epitaxial growth **characterized in that** a plane shaped reformed domain pattern (3) is formed within a monocrystalline substrate (1), used for formation of monocrystalline layers by epitaxial growth, by means of multiphoton absorption of a pulsed laser beam (2) that is condensed and scanned through a polished surface of the monocrystalline substrate (1), wherein the warp shape and / or amount of warping of the monocrystalline substrate (1) are controlled, wherein the material of the monocrystalline substrate (1) is any of sapphire, nitride semiconductor, Si, GaAs, quartz crystal or SiC.

23. The method of manufacturing reformed domain substrates according to claim 22, wherein at least one crystal layer is formed on the growth surface of the internally reformed substrate (1) in crystal growth bodies.

24. The method of manufacturing reformed domain substrates according to claim 23, wherein the crystal growth bodies are used for fabricating devices.

25. The method of manufacturing reformed domain substrates according to claim 23, wherein the crystal growth body is a thick film, which is used for fabricating bulk substrates.

26. The method of manufacturing reformed domain substrates according to claim 22, wherein the substrate is a sapphire substrate for semiconductor layer epitaxial growth used for formation of semiconductor layers by epitaxial growth.

27. The method of manufacturing reformed domain substrates according to claim 26, wherein at least one semiconductor layer is formed on a growth surface of the internally reformed sapphire substrate (7) in semiconductor layer growth bodies.

28. The method of manufacturing reformed domain substrates according to claim 27, wherein the semiconductor layer growth bodies are used for fabrication of semiconductor devices.

29. The method of manufacturing reformed domain substrates according to claim 27, wherein the semiconductor layer growth bodies are thick layers, which are used for fabrication of semiconductor bulk substrates.

30. The method of manufacturing reformed domain substrates according to claim 22, wherein the sapphire substrate (7) is used for formation of nitride semiconductor layers by epitaxial growth.

31. The method of manufacturing reformed domain substrates according to claim 30, wherein the plane shape of at least one type of reformed domain pattern (3) is any of a striped shape, a lattice shape, a distribution of multiple polygons, a concentric circular shape, a spiral shape or broken lines or dots that are symmetrical with respect to a vertical line through the center point of the sapphire substrate (7).

32. The method of manufacturing reformed domain substrates according to claim 31, wherein the position of formation of the at least one type of reformed domain pattern (3) is between 3% and 95% of the thickness of the sapphire substrate (7) from the growth surface of the sapphire substrate (7) and the pitch (4) between lines making up the reformed domain pattern (3) is at least 50 µm and no more than 2000 µm.

33. The method of manufacturing reformed domain substrates according to claim 31, wherein the plane shape of at least one type of reformed domain pattern (3) is any of broken lines or dots that are symmetrical with respect to a vertical line through the center point of the sapphire substrate (7) or a lattice pattern and the reformed domain pattern (3) is positioned between 3% and 50% of the thickness of the sapphire substrate (7) from the growth surface of the sapphire substrate (7) and the pitch (4) between lines making up the reformed domain pattern (3) is at least 50 µm and no more than 2000 µm.

34. The method of manufacturing reformed domain substrates according to anyone of claims 30 to 33, wherein at least one nitride semiconductor layer is formed on the growth surface of the internally reformed sapphire substrate (7) in nitride semiconductor layer growth bodies.

35. The method of manufacturing reformed domain substrates according to claim 34, wherein the nitride semiconductor layer growth bodies are used for fabrication of nitride semiconductor devices.

36. The method of manufacturing reformed domain substrates according to claim 35, wherein the nitride semiconductor devices are any of a photo-emitter element, an electron device, or a photo-receptor element.

37. The method of manufacturing reformed domain substrates according to claim 34, wherein the nitride semiconductor layer growth body is a thick layer, which is used for fabrication of nitride semiconductor bulk substrates.

38. The method of manufacturing reformed domain substrates according to claim 37, wherein the nitride semiconductor bulk substrate comprises AlₓIn_{y}Ga_{z}N, and wherein x+y+z=1, x≥0, y≥0, and z≥0.

39. The method of manufacturing reformed domain substrates according to anyone of claims 26 to 38, wherein the shape of the sapphire substrate (7) prior to formation of the reformed domain pattern (3) has a semiconductor layer growth surface that is concave and the curvature of the concave surface is greater than 0 km⁻¹ and not greater than 160 km⁻¹.

40. The method of manufacturing reformed domain substrates according to anyone of claims 26 to 38, wherein the shape of the sapphire substrate (7) prior to formation of the reformed domain pattern (3) has a semiconductor layer growth surface that is concave and the curvature of the concave surface is greater than 40 km⁻¹ and not greater than 150 km⁻¹.

41. The method of manufacturing reformed domain substrates according to anyone of claims 26 to 38, wherein the shape of the sapphire substrate (7) prior to formation of the reformed domain pattern (3) has a semiconductor layer growth surface that is concave and the curvature of the concave surface is greater than 85 km⁻¹ and not greater than 150 km⁻¹.

42. The method of manufacturing reformed domain substrates according to anyone of claims 39 to 41, wherein the diameter of the sapphire substrate (7) prior to formation of the reformed domain pattern (3) is at least 50 mm and no more than 300 mm and its thickness is at least 0,05 mm and no more than 5,0 mm.

## Patentansprüche

1. Intern reformiertes Einkristallsubstrat (1) für epitaxiales Wachstum einkristalliner Schichten, erhältlich durch das Verfahren nach einem der Ansprüche 22 bis 42, **dadurch gekennzeichnet, dass** reformierte Domänenmuster (3), die eine ebene Form haben, innerhalb des Einkristallsubstrats (1) mittels Mehrphotonenabsorption eines gepulsten Laserstrahls (2) gebildet sind, zur Steuerung einer Krümmungsform und/oder eines Betrags der Krümmung des Einkristallsubstrats (1), wobei das Material des Einkristallsubstrats (1) Saphir, Nitridhalbleiter, Si, GaAs, Quarzkristall oder SiC ist.

2. Intern reformiertes Einkristallsubstrat (1) nach Anspruch 1, das eine Wachstumsfläche für epitaxiales Wachstum hat, wobei wenigstens eine Kristallschicht auf der Wachstumsfläche in einem Kristallwachstumsschichtkörper gebildet ist.

3. Intern reformiertes Einkristallsubstrat (1) nach Anspruch 2, wobei der Kristallwachstumsschichtkörper ein Kristallwachstumsschichtkörper in einem Bauelement ist.

4. Intern reformiertes Einkristallsubstrat (1) nach Anspruch 2, wobei die Kristallwachstumsschicht eine Dickschicht in einem Massensubstrat ist.

5. Intern reformiertes Einkristallsubstrat nach Anspruch 1, wobei das Einkristallsubstrat ein Saphirsubstrat für epitaxiales Wachstum einer Halbleiterschicht ist.

6. Intern reformiertes Einkristallsubstrat nach Anspruch 5, wobei wenigstens eine Halbleiterschicht auf einer Wachstumsfläche des Saphirsubstrats in einem Halbleiterschichtwachstumskörper gebildet ist.

7. Intern reformiertes Einkristallsubstrat nach Anspruch 6, wobei der Halbleiterwachstumsschichtkörper ein Wachstumsschichtkörper in einem Halbleiterbauelement ist.

8. Intern reformiertes Einkristallsubstrat nach Anspruch 6, wobei die Halbleiterschicht eine Dickschicht in einem Massenhalbleitersubstrat ist.

9. Intern reformiertes Einkristallsubstrat (1) nach Anspruch 1, wobei das Einkristallsubstrat (1) ein Saphirsubstrat (7) für epitaxiales Wachstum einer Nitridhalbleiterschicht ist.

10. Intern reformiertes Einkristallsubstrat (1) nach Anspruch 9, wobei die ebene Form wenigstens eines Typs der reformierten Domänenmuster eine Streifenform, eine Gitterform, eine Verteilung mehrerer Polygone, eine konzentrische Kreisform, eine Spiralform oder unterbrochene Linien oder Punkte ist/sind, die bezüglich einer Vertikalen durch den Mittelpunkt des Saphirsubstrats (7) symmetrisch sind.

11. Intern reformiertes Einkristallsubstrat (1) nach Anspruch 9 oder 10, wobei die Position der Bildung des wenigstens einen Typs von reformiertem Domänenmuster zwischen 3% und 95% der Dicke des Saphirsubstrats (7) von der Wachstumsfläche des Saphirsubstrats (7) beträgt und ein Abstand (4) zwischen Linien, die das reformierte Domänenmuster (3) bilden, wenigstens 50 µm und nicht mehr als 2000 µm beträgt.

12. Intern reformiertes Einkristallsubstrat (3) nach Anspruch 9 oder 10, wobei die ebene Form des wenigstens einen Typs von reformiertem Domänenmuster (3) unterbrochene Linien oder Punkte sind, die bezüglich einer Vertikalen durch den Mittelpunkt des Saphirsubstrats symmetrisch sind, oder ein Gittermuster ist, und das reformierte Domänenmuster zwischen 3% und 50% der Dicke des Saphirsubstrats (7) von der Wachstumsfläche des Saphirsubstrats (7) positioniert ist und der Abstand zwischen Linien, die das reformierte Domänenmuster (3) bilden, wenigstens 50 µm und nicht mehr als 2000 µm beträgt.

13. Intern reformiertes Einkristallsubstrat (1) nach einem der Ansprüche 9 bis 12, das eine Wachstumsfläche für epitaxiales Wachstum hat, wobei wenigstens eine Nitridhalbleiterschicht auf der Wachstumsfläche in einem Nitridhalbleiterschichtwachstumskörper gebildet ist.

14. Intern reformiertes Einkristallsubstrat (1) nach Anspruch 13, wobei das intern reformierte Einkristallsubstrat ein Einkristallsubstrat in einem Nitridhalbleiterbauelement ist.

15. Intern reformiertes Einkristallsubstrat (1) nach Anspruch 14, wobei das Nitridhalbleiterbauelement ein Photoemitterelement, eine Elektronenvorrichtung oder ein Photorezeptorelement ist.

16. Intern reformiertes Einkristallsubstrat (1) nach Anspruch 13, wobei die Nitridhalbleiterschicht eine Dickschicht in einem Massennitridhalbleitersubstrat ist.

17. Intern reformiertes Einkristallsubstrat (1) nach Anspruch 16, wobei das Massennitridhalbleitersubstrat AlₓIn_{y}Ga_{z}N umfasst, wobei x+y+z=1, x≥0, y≥0 und z≥0 ist.

18. Intern reformiertes Einkristallsubstrat (1) nach einem der Ansprüche 5 bis 17, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 0 km⁻¹ und nicht größer als 160 km⁻¹ ist.

19. Intern reformiertes Einkristallsubstrat (1) nach einem der Ansprüche 5 bis 17, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 40 km⁻¹ und nicht größer als 150 km⁻¹ ist.

20. Intern reformiertes Einkristallsubstrat (1) nach einem der Ansprüche 5 bis 17, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 85 km⁻¹ und nicht größer als 150 km⁻¹ ist.

21. Intern reformiertes Einkristallsubstrat (1) nach einem der Ansprüche 18 bis 20, wobei ein Durchmesser des Saphirsubstrats (7) vor Bildung des reformierten Domänenmusters (3) wenigstens 50 mm und nicht mehr als 300 mm beträgt und seine Dicke wenigstens 0,05 mm und nicht mehr als 5,0 mm beträgt.

22. Verfahren zur Herstellung reformierter Domänensubstrate für epitaxiales Wachstum, **dadurch gekennzeichnet, dass** ein eben geformtes, reformiertes Domänenmuster (3) innerhalb eines Einkristallsubstrats (1) gebildet wird, das zur Bildung einkristalliner Schichten durch epitaxiales Wachstum verwendet wird, mittels Mehrphotonenabsorption eines gepulsten Laserstrahls (2), der durch eine polierte Oberfläche des Einkristallsubstrats (1) gebündelt und abgetastet wird, wobei die Krümmungsform und/oder der Betrag der Krümmung des Einkristallsubstrats (1) gesteuert werden, wobei das Material des Einkristallsubstrats (1) Saphir, Nitridhalbleiter, Si, GaAs, Quarzkristall oder SiC ist.

23. Verfahren zur Herstellung reformierter Domänensubstrate nach Anspruch 22, wobei wenigstens eine Kristallschicht auf der Wachstumsfläche des intern reformierten Substrats (1) in Kristallwachstumskörpern gebildet wird.

24. Verfahren zur Herstellung reformierter Domänensubstrate nach Anspruch 23, wobei die Kristallwachstumskörper zur Fertigung von Bauelementen verwendet werden.

25. Verfahren zur Herstellung reformierter Domänensubstrate nach Anspruch 23, wobei der Kristallwachstumskörper eine Dickschicht ist, die zur Fertigung von Massensubstraten verwendet wird.

26. Verfahren zur Herstellung reformierter Domänensubstrate nach Anspruch 22, wobei das Substrat ein Saphirsubstrat für Halbleiterschichtepitaxialwachstum ist, das zur Bildung von Halbleiterschichten durch epitaxiales Wachstum verwendet wird.

27. Verfahren zur Herstellung reformierter Domänensubstrate nach Anspruch 26, wobei wenigstens eine Halbleiterschicht auf einer Wachstumsfläche des intern reformierten Saphirsubstrats (7) in Halbleiterschichtwachstumskörpern gebildet wird.

28. Verfahren zur Herstellung reformierter Domänensubstrate nach Anspruch 27, wobei die Halbleiterschichtwachstumskörper zur Fertigung von Halbleiterbauelementen verwendet werden.

29. Verfahren zur Herstellung reformierter Domänensubstrate nach Anspruch 27, wobei die Halbleiterschichtwachstumskörper Dickschichten sind, die zur Fertigung von Halbleitermassensubstraten verwendet werden.

30. Verfahren zur Herstellung reformierter Domänensubstrate nach Anspruch 22, wobei das Saphirsubstrat (7) zur Bildung von Nitridhalbleiterschichten durch epitaxiales Wachstum verwendet wird.

31. Verfahren zur Herstellung reformierter Domänensubstrate nach Anspruch 30, wobei die ebene Form wenigstens eines Typs von reformiertem Domänenmuster (3) eine Streifenform, eine Gitterform, eine Verteilung mehrerer Polygone, eine konzentrische Kreisform, eine Spiralform oder unterbrochene Linien oder Punkte ist/sind, die bezüglich einer Vertikalen durch den Mittelpunkt des Saphirsubstrats (7) symmetrisch sind.

32. Verfahren zur Herstellung reformierter Domänensubstrate nach Anspruch 31, wobei die Position der Bildung des wenigstens einen Typs von reformiertem Domänenmuster (3) zwischen 3% und 95% der Dicke des Saphirsubstrats (7) von der Wachstumsfläche des Saphirsubstrats (7) beträgt und der Abstand (4) zwischen Linien, die das reformierte Domänenmuster (3) bilden, wenigstens 50 µm und nicht mehr als 2000 µm beträgt.

33. Verfahren zur Herstellung reformierter Domänensubstrate nach Anspruch 31, wobei die ebene Form wenigstens eines Typs von reformiertem Domänenmuster (3) unterbrochene Linien oder Punkte sind, die bezüglich einer Vertikalen durch den Mittelpunkt des Saphirsubstrats (7) symmetrisch sind, oder ein Gittermuster ist, und das reformierte Domänenmuster (3) zwischen 3% und 50% der Dicke des Saphirsubstrats (7) von der Wachstumsfläche des Saphirsubstrats (7) positioniert ist und der Abstand (4) zwischen Linien, die das reformierte Domänenmuster (3) bilden, wenigstens 50 µm und nicht mehr als 2000 µm beträgt.

34. Verfahren zur Herstellung reformierter Domänensubstrate nach einem der Ansprüche 30 bis 33, wobei wenigstens eine Nitridhalbleiterschicht auf der Wachstumsfläche des intern reformierten Saphirsubstrats (7) in Nitridhalbleiterschichtwachstumskörpern gebildet wird.

35. Verfahren zur Herstellung reformierter Domänensubstrate nach Anspruch 34, wobei die Nitridhalbleiterschichtwachstumskörper zur Fertigung von Nitridhalbleiterbauelementen verwendet werden.

36. Verfahren zur Herstellung reformierter Domänensubstrate nach Anspruch 35, wobei die Nitridhalbleiterbauelemente ein Photoemitterelement, eine Elektronenvorrichtung oder ein Photorezeptorelement sind.

37. Verfahren zur Herstellung reformierter Domänensubstrate nach Anspruch 34, wobei der Nitridhalbleiterschichtwachstumskörper eine Dickschicht ist, die zur Fertigung von Nitridhalbleitermassensubstraten verwendet wird.

38. Verfahren zur Herstellung reformierter Domänensubstrate nach Anspruch 37, wobei das Nitridhalbleitermassensubstrat AlₓIn_{y}Ga_{z}N umfasst und wobei x+y+z=1, x≥0, y≥0 und z≥0 ist.

39. Verfahren zur Herstellung reformierter Domänensubstrate nach einem der Ansprüche 26 bis 38, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 0 km⁻¹ und nicht größer als 160 km⁻¹ ist.

40. Verfahren zur Herstellung reformierter Domänensubstrate nach einem der Ansprüche 26 bis 38, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 40 km⁻¹ und nicht größer als 150 km⁻¹ ist.

41. Verfahren zur Herstellung reformierter Domänensubstrate nach einem der Ansprüche 26 bis 38, wobei die Form des Saphirsubstrats (7) vor Bildung des reformierten Domänenmusters (3) eine Halbleiterschichtwachstumsfläche hat, die konkav ist, und die Krümmung der konkaven Fläche größer als 85 km⁻¹ und nicht größer als 150 km⁻¹ ist.

42. Verfahren zur Herstellung reformierter Domänensubstrate nach einem der Ansprüche 39 bis 41, wobei der Durchmesser des Saphirsubstrats (7) vor Bildung des reformierten Domänenmusters (3) wenigstens 50 mm und nicht mehr als 300 mm beträgt und seine Dicke wenigstens 0,05 mm und nicht mehr als 5,0 mm beträgt.

## Revendications

1. Substrat monocristallin (1) réformé par voie interne pour la croissance épitaxiale de couches monocristallines, apte à être obtenu par le procédé selon l'une des revendications 22 à 42, **caractérisé en ce que** des motifs de domaine réformés (3) présentant une forme plane sont réalisés à l'intérieur du substrat monocristallin (1) par absorption multiphotonique d'un rayon laser (2) pulsé pour la commande d'une forme de courbure et/ou d'une valeur de courbure du substrat monocristallin (1), la matière du substrat monocristallin (1) étant du saphir, un semi-conducteur à base de nitrure, du Si, du GaAs, du cristal de quartz ou du SiC.

2. Substrat monocristallin (1) réformé par voie interne selon la revendication 1, présentant une surface de croissance pour la croissance épitaxiale, au moins une couche de cristal étant réalisée sur la surface de croissance dans un corps de couche de croissance de cristal.

3. Substrat monocristallin (1) réformé par voie interne selon la revendication 2, le corps de couche de croissance de cristal étant un corps de couche de croissance de cristal dans un composant.

4. Substrat monocristallin (1) réformé par voie interne selon la revendication 2, la couche de croissance de cristal étant une couche épaisse dans un substrat massif.

5. Substrat monocristallin réformé par voie interne selon la revendication 1, le substrat monocristallin étant un substrat en saphir pour la croissance épitaxiale d'une couche de semi-conducteur.

6. Substrat monocristallin réformé par voie interne selon la revendication 5, au moins une couche de semi-conducteur étant réalisée sur une surface de croissance du substrat en saphir dans un corps de croissance de couche de semi-conducteur.

7. Substrat monocristallin réformé par voie interne selon la revendication 6, le corps de couche de croissance de semi-conducteur étant un corps de couche de croissance dans un composant semi-conducteur.

8. Substrat monocristallin réformé par voie interne selon la revendication 6, la couche de semi-conducteur étant une couche épaisse dans un substrat semi-conducteur massif.

9. Substrat monocristallin (1) réformé par voie interne selon la revendication 1, le substrat monocristallin (1) étant un substrat en saphir (7) pour la croissance épitaxiale d'une couche de semi-conducteur à base de nitrure.

10. Substrat monocristallin (1) réformé par voie interne selon la revendication 9, la forme plane d'au moins un type des motifs de domaine réformés étant une forme en bande, une forme en grille, une distribution de plusieurs polygones, une forme circulaire concentrique, une forme en spirale ou des lignes interrompues ou des points symétriques par rapport à une ligne verticale à travers le point central du substrat en saphir (7).

11. Substrat monocristallin (1) réformé par voie interne selon la revendication 9 ou 10, la position de la formation dudit au moins un type de motif de domaine réformé étant entre 3 % et 95 % de l'épaisseur du substrat en saphir (7) depuis la surface de croissance du substrat en saphir (7), et la distance (4) entre des lignes formant le motif de domaine réformé (3) étant d'au moins 50 µm et pas supérieure à 2000 µm.

12. Substrat monocristallin (3) réformé par voie interne selon la revendication 9 ou 10, la forme plane dudit au moins un type de motif de domaine réformé (3) étant des lignes interrompues ou des points symétriques par rapport à une ligne verticale à travers le point central du substrat en saphir, ou un motif en grille, et le motif de domaine réformé étant positionné entre 3 % et 50 % de l'épaisseur du substrat en saphir (7) depuis la surface de croissance du substrat en saphir (7), et la distance entre des lignes formant le motif de domaine réformé (3) étant d'au moins 50 µm et pas supérieure à 2000 µm.

13. Substrat monocristallin (1) réformé par voie interne selon l'une des revendications 9 à 12, présentant une surface de croissance pour une croissance épitaxiale, au moins une couche de semi-conducteur à base de nitrure étant réalisée sur la surface de croissance dans un corps de croissance de couche de semi-conducteur à base de nitrure.

14. Substrat monocristallin (1) réformé par voie interne selon la revendication 13, le substrat monocristallin réformé par voie interne étant un substrat monocristallin dans un composant semi-conducteur à base de nitrure.

15. Substrat monocristallin (1) réformé par voie interne selon la revendication 14, le composant semi-conducteur à base de nitrure étant un élément photoémetteur, un dispositif électronique ou un élément photorécepteur.

16. Substrat monocristallin (1) réformé par voie interne selon la revendication 13, la couche de semi-conducteur à base de nitrure étant une couche épaisse dans un substrat semi-conducteur massif à base de nitrure.

17. Substrat monocristallin (1) réformé par voie interne selon la revendication 16, le substrat semi-conducteur massif à base de nitrure comprenant du AlₓIn_{y}Ga_{z}N, avec x + y + z = 1,x ≥ 0, y ≥ 0 et z ≥ 0.

18. Substrat monocristallin (1) réformé par voie interne selon l'une des revendications 5 à 17, la forme du substrat en saphir (7) présentant avant la réalisation du motif de domaine réformé (3) une surface de croissance de couche de semi-conducteur qui est concave, et la courbure de la surface concave étant supérieure à 0 km⁻¹ et pas supérieure à 160 km⁻¹.

19. Substrat monocristallin (1) réformé par voie interne selon l'une des revendications 5 à 17, la forme du substrat en saphir (7) présentant avant la réalisation du motif de domaine réformé (3) une surface de croissance de couche de semi-conducteur qui est concave, et la courbure de la surface concave étant supérieure à 40 km⁻¹ et pas supérieure à 150 km⁻¹.

20. Substrat monocristallin (1) réformé par voie interne selon l'une des revendications 5 à 17, la forme du substrat en saphir (7) présentant avant la réalisation du motif de domaine réformé (3) une surface de croissance de couche de semi-conducteur qui est concave, et la courbure de la surface concave étant supérieure à 85 km⁻¹ et pas supérieure à 150 km⁻¹.

21. Substrat monocristallin (1) réformé par voie interne selon l'une des revendications 18 à 20, un diamètre du substrat en saphir (7), avant la réalisation du motif de domaine réformé (3), étant d'au moins 50 mm et pas supérieur à 300 mm, et son épaisseur étant d'au moins 0,05 mm et pas supérieure à 5,0 mm.

22. Procédé de fabrication de substrats de domaine réformés pour la croissance épitaxiale, **caractérisé en ce qu'**un motif de domaine réformé (3) formé de manière plane est réalisé dans un substrat monocristallin (1) utilisé pour la réalisation de couches monocristallines par croissance épitaxiale par absorption multiphotonique d'un rayon laser (2) pulsé qui est condensé et balayé par une surface polie du substrat monocristallin (1), la forme de courbure et/ou la valeur de la courbure du substrat monocristallin (1) étant commandées, la matière du substrat monocristallin (1) étant du saphir, un semi-conducteur à base de nitrure, du Si, du GaAs, du cristal de quartz ou du SiC.

23. Procédé de fabrication de substrats de domaine réformés selon la revendication 22, au moins une couche de cristal étant réalisée sur la surface de croissance du substrat (1) réformé par voie interne dans des corps de croissance de cristal.

24. Procédé de fabrication de substrats de domaine réformés selon la revendication 23, les corps de croissance de cristal étant utilisés pour la production de composants.

25. Procédé de fabrication de substrats de domaine réformés selon la revendication 23, le corps de croissance de cristal étant une couche épaisse utilisée pour la production de substrats massifs.

26. Procédé de fabrication de substrats de domaine réformés selon la revendication 22, le substrat étant un substrat en saphir pour la croissance épitaxiale de couche de semi-conducteur utilisée pour la réalisation de couches de semi-conducteur par croissance épitaxiale.

27. Procédé de fabrication de substrats de domaine réformés selon la revendication 26, au moins une couche de semi-conducteur étant réalisée sur une surface de croissance du substrat en saphir (7) réformé par voie interne dans des corps de croissance de couche de semi-conducteur.

28. Procédé de fabrication de substrats de domaine réformés selon la revendication 27, les corps de croissance de couche de semi-conducteur étant utilisés pour la production de composants semi-conducteurs.

29. Procédé de fabrication de substrats de domaine réformés selon la revendication 27, les corps de croissance de couche de semi-conducteur étant des couches épaisses utilisées pour la production de substrats semi-conducteurs massifs.

30. Procédé de fabrication de substrats de domaine réformés selon la revendication 22, le substrat en saphir (7) étant utilisé pour la réalisation de couches de semi-conducteur à base de nitrure par croissance épitaxiale.

31. Procédé de fabrication de substrats de domaine réformés selon la revendication 30, la forme plane d'au moins un type de motif de domaine réformé (3) étant une forme en bande, une forme en grille, une distribution de plusieurs polygones, une forme circulaire concentrique, une forme en spirale ou des lignes interrompues ou des points symétriques par rapport à une ligne verticale à travers le point central du substrat en saphir (7).

32. Procédé de fabrication de substrats de domaine réformés selon la revendication 31, la position de la formation dudit au moins un type de motif de domaine réformé (3) étant entre 3 % et 95 % de l'épaisseur du substrat en saphir (7) depuis la surface de croissance du substrat en saphir (7), et la distance (4) entre des lignes formant le motif de domaine réformé (3) étant d'au moins 50 µm et pas supérieure à 2000 µm.

33. Procédé de fabrication de substrats de domaine réformés selon la revendication 31, la forme plane dudit au moins un type de motif de domaine réformé (3) étant des lignes interrompues ou des points symétriques par rapport à une ligne verticale à travers le point central du substrat en saphir (7), ou un motif en grille, et le motif de domaine réformé (3) étant positionné entre 3 % et 50 % de l'épaisseur du substrat en saphir (7) depuis la surface de croissance du substrat en saphir (7), et la distance (4) entre des lignes formant le motif de domaine réformé (3) étant d'au moins 50 µm et pas supérieure à 2000 µm.

34. Procédé de fabrication de substrats de domaine réformés selon l'une des revendications 30 à 33, au moins une couche de semi-conducteur à base de nitrure étant réalisée sur la surface de croissance du substrat en saphir (7) réformé par voie interne dans des corps de croissance de couche de semi-conducteur à base de nitrure.

35. Procédé de fabrication de substrats de domaine réformés selon la revendication 34, les corps de croissance de couche de semi-conducteur à base de nitrure étant utilisés pour la production de composants semi-conducteurs à base de nitrure.

36. Procédé de fabrication de substrats de domaine réformés selon la revendication 35, les composants semi-conducteurs à base de nitrure étant un élément photoémetteur, un dispositif électronique ou un élément photorécepteur.

37. Procédé de fabrication de substrats de domaine réformés selon la revendication 34, le corps de croissance de couche de semi-conducteur à base de nitrure étant une couche épaisse utilisée pour la production de substrats semi-conducteurs massifs à base de nitrure.

38. Procédé de fabrication de substrats de domaine réformés selon la revendication 37, le substrat semi-conducteur massif à base de nitrure comprenant du AlₓIn_{y}Ga_{z}N, avec x + y + z = 1, x ≥ 0, y ≥ 0 et z ≥ 0.

39. Procédé de fabrication de substrats de domaine réformés selon l'une des revendications 26 à 38, la forme du substrat en saphir (7) présentant avant la réalisation du motif de domaine réformé (3) une surface de croissance de couche de semi-conducteur qui est concave, et la courbure de la surface concave étant supérieure à 0 km⁻¹ et pas supérieure à 160 km⁻¹.

40. Procédé de fabrication de substrats de domaine réformés selon l'une des revendications 26 à 38, la forme du substrat en saphir (7) présentant avant la réalisation du motif de domaine réformé (3) une surface de croissance de couche de semi-conducteur qui est concave, et la courbure de la surface concave étant supérieure à 40 km⁻¹ et pas supérieure à 150 km⁻¹.

41. Procédé de fabrication de substrats de domaine réformés selon l'une des revendications 26 à 38, la forme du substrat en saphir (7) présentant avant la réalisation du motif de domaine réformé (3) une surface de croissance de couche de semi-conducteur qui est concave, et la courbure de la surface concave étant supérieure à 85 km⁻¹ mais pas supérieure à 150 km⁻¹.

42. Procédé de fabrication de substrats de domaine réformés selon l'une des revendications 39 à 41, le diamètre du substrat en saphir (7) avant la réalisation du motif de domaine réformé (3) étant d'au moins 50 mm et pas supérieur à 300 mm, et son épaisseur étant d'au moins 0,05 mm et pas supérieure à 5,0 mm.
